**Europäisches Patentamt**

**European Patent Office**

**Office européen des brevets**

(19)

(11) Veröffentlichungsnummer : **0 008 016**
**B1**

(12) **EUROPÄISCHE PATENTSCHRIFT**

(45) Veröffentlichungstag der Patentschrift :
**13.01.82**

(21) Anmeldenummer : **79102453.2**

(22) Anmeldetag : **16.07.79**

(51) Int. Cl.³ : **G 06 F 11/12, H 04 J 6/00,**
**H 04 L 1/10**

(54) **Verfahren sowie Sende- und Empfangseinrichtung zur Datenübertragung mit adaptiver Fehlersicherung.**

(30) Priorität : **10.08.78 US 932579**

(43) Veröffentlichungstag der Anmeldung :
**20.02.80 (Patentblatt 80/04)**

(45) Bekanntmachung des Hinweises auf die Patenterteilung : **13.01.82 Patentblatt 82/02**

(84) Benannte Vertragsstaaten :
**AT DE FR GB SE**

(56) Entgegenhaltungen :
**DE - B - 1 296 192**
**DE - B - 2 015 345**
**DE - A - 2 310 222**
**US - A - 4 047 151**

**E. Herter, H. Rupp « NACHRICHTENÜBERTRA-**
**GUNG ÜBER SATELLITEN », 1979, Springer**
**Verlag, Berlin-Heidelberg-New York, Seiten 31-**
**33, 57-62, 185-186**

(73) Patentinhaber : **International Business Machines Cor-**
**poration**

**Armonk, N.Y. 10504 (US)**

(72) Erfinder : **Alvarez III, Joseph Anthony**
**10101 Johns Drive**
**Damascus, Maryland 20750 (US)**
Erfinder : **Gobioff, Bruce Dean**
**13410 Norden Drive**
**Wheaton, Maryland 20906 (US)**
Erfinder : **West, Lynn Parker**
**12211 Wallingstone Lane**
**Austin, Texas 78750 (US)**

(74) Vertreter : **Lewit, Leonard, Dipl.-Ing.**
**Schönaicher Strasse 220**
**D-7030 Böblingen (DE)**

Imprimerie Jouve, 18, rue St-Denis, 75001 Paris, France

# Verfahren sowie Sende- und Empfangseinrichtung zur Datenübertragung mit adaptiver Fehlersicherung

Die Erfindung betrifft ein Verfahren zur Datenübertragung nach dem Oberbegriff des Anspruchs 1 sowie eine Sende- und eine Empfangseinrichtung zur Durchführung des Verfahrens. Ein Zeitmultiplexsystem mit Vielfachzugriff (TDMA Time Division Multiple Access) ist z.B. in der US-PS 4 009 344 beschrieben. Ein Zeitmultiplexrahmen besteht darin aus mehreren Kanalbündel wobei jedes Bündel von einer anderen Station gesendet und empfangen wird. Zum Unterschied hiervon weisen ältere Zeitmultiplexsysteme keine Kanalbündel auf, sondern nur einen Multiplexrahmen, der aus einzelnen Känalen besteht.

In einem solchen älteren System wurde bereits eine adaptive Fehlersicherung durchgeführt, wie aus der US-PS 3 534 264 hervorgeht. Zur Erhöhung der Sicherheit gegen Übertragungsfehler wird in diesem bekannten System die Dauer eines Bitsignales und damit die gesendete Energie erhöht. Dabei ändert sich das Format eines ganzen Zeitrahmens, so daß eine Anpassung einzelner Kanäle an gestörte Übertragungsstrecken nicht möglich ist. Der Wechsel, des Datenformates wird dabei durch Steuersignale angegeben, welche in dem dem Wechsel vorhergehenden Zeitrahmen zu den anderen Stationen übertragen werden. Die Empfangsstationen können hierdurch noch rechtzeitig auf die Formatsänderung durch Änderung der Taktsignale insbesondere für die Demodulationsschaltungen reagieren. Dieses Verfahren arbeitet jedoch dann uneffektiv, wenn ein Teil der übertragenen Daten weniger und der andere Teil mehr durch Übertragungsstörungen beeinträchtigt wird. In einer solchen Datenübertragung kann z.B. eine digitale Telephonieübertragung noch verständlich sein, während übertragene Rechnerdaten unbrauchbar werden.

Die Anwendung der in der US-PS 3 534 264 beschriebenen adaptiven Fehlersicherungstechnik bei einem Zeitmultiplexsystem mit Vielfachzugriff, etwa der in der US-PS 4 009 344 beschriebenen Art, würde einige Nachteile mit sich bringen. In dem beschriebenen Zeitmultiplexsystem werden von mehreren Stationen aus Bündel von Daten zu einem Satelliten-Transponder gesendet und von diesem nach Frequenzumsetzung wieder zu den Stationen zurückgestrahlt. Die Daten in den Kanälen eines Bündels können dabei von verschiedenen Teilnehmeranschlüssen kommen und können ebenso auch verschiedene Bestimmungsziele haben. In jeder Station ist ein Pufferspeicher vorgesehen, dessen Kapazität jedoch nur ausreicht, die gerade zu den Anschlüssen der Station zu übertragenden Daten zu speichern. Diese für eine einzige Station bestimmten Daten stellen normalerweise nur einen kleinen Bruchteil der vom Satelliten ausgestrahlten Informationsmenge dar. Daher müssen aus dem von einer bestimmten Station vom Satelliten empfangenen Informationsgemisch die für diese Station bestimmten Daten sofort selektiert und weiter geleitet werden.

In der US-PS 3 534 264 empfängt eine Station alle von einer anderen Station ausgesendeten Daten. Bei einer Anpassung an momentane Störungsverhältnisse werden Steuernachrichten zu der sendenden Station übermittelt, welche daraufhin zur besseren Fehlersicherung das Rahmenformat ändert.

Wollte man eine solche Technik in einem TDMA-System anwenden, in dem wie beschrieben eine erste Station nur einen einzigen Kanal aus dem von einer zweiten Station ausgesandten Kanalbündel empfängt, so würde eine Formatänderung bei der zweiten Station auch die von dritten und weiteren Stationen empfangenen Kanäle beeinflussen. Hierdurch könnte jedoch der Wirkungsgrad des Systems ganz erheblich leiden, da auch das Format von Kanälen geändert würde, die zu Stationen gesandt werden, welche keine Störungen festgestellt haben.

Aus der US-PS 4 047 151 ist ein weiteres Zeitmultiplexübertragungssystem mit adaptiver Fehlersicherung bekannt geworden. Das System wird als Telefonie-Vermittlungssystem verwendet, wobei Abtastwerte der Sprachamplituden als Pulscodemodulationswörter übertragen werden. Dabei wird die Anzahl von PCM-Bits, die zur Codierung eines Amplitudenwertes herangezogen werden vermindert, wenn durch Messung von digitalen Fehlern und/oder des Signal-Rauschverhältnisses für digitale Signale eine erhöhte Fehlerrate festgestellt wird, wobei in den freigewordenen Bitplätzen, und eventuell in anderen PCM-Wörtern redundante Prüfbits übertragen werden. Es ist klar, daß eine solche Methode nur in solchen Fällen verwendet werden kann, in denenes auf den genauen Wert der übertragenen Amplitude nicht ankommt und in denen eine verminderte Verständlichkeit keine Rolle spielt. Selbst in solchen Fällen jedoch wird die Zahl der zusätzlichen redundanten Prüfbits beschränkt bleiben und damit auch die zusätzlichen Fehlererkennungsmöglichkeiten. Für die Übertragung von Rechnerdaten ist diese Methode unbrauchbar. Die Umschaltung vom Normal-Übertragungsmodus auf den Fehlersicherungs-Übertragungsmodus erfolgt aufgrund von übertragener Steuerinformation, welche die Übertraungseigenschaften der verwendeten Übertragungswege angibt.

Der Artikel « Techniques for Introducing Error Correcting Codes into TDMA Satellite Communication Systems », von N. Rydbeck und C.E. Sundberg in Ericsson Technics Nº 4, 1975, bezieht sich auf ein ähnliches Übertragungssystem. Das von jeder Bodenstation zum Übertragungs-Satelliten ausgesendete Kanalbündel (Burst) weist eine sogenannte Präambel und eine Reihe von aufeinanderfolgenden PCM-Wörtern auf.

Jedes PCM-Wort weist 8 Bits auf und kann jeweils für ein anderes Ziel bestimmt sein. Die Präambel enthält Synchronisationssignale, eine Sender-Identifikation, Signalisierungssignale und

Adressen für Telefonsignale.

Der vorliegenden Erfindung liegt die Aufgabe zugrunde, ein Verfahren und eine Einrichtung anzugeben, mit denen eine adaptive Fehlersicherung von einzelnen Kanälen in einem Bündel ohne drastische Eingriffe in das Übertragungssystem und ohne Verstümmelung der zu übertragenden Information erreicht wird. Die Lösung dieser Aufgabe ist im Verfahrens-Hauptanspruch und in den Einrichtungs-ansprüchen gekennzeichnet.

Die Erfindung hat den Vorteil, daß die adaptive Fehlersicherung selektiv und auch zeitlich vorübergehend auf einzelne Kanäle angewendet werden kann. Dabei treten die Fehlersicherungs-Bits nicht an die Stelle von einzelnen Informations-Bits einer zusammenhängenden Nachricht, so daß keine Verstümmelung dieser Nachricht und auch kein Quantisierungsfehler eintritt. Ferner kann das Format der übertragenen Daten in ausgewählten Kanälen des übertragenen Kanalbündels auch als Funktion der Bedeutung der Daten, ihrer Fehleranfälligkeit, der verfügbaren Kanalkapazität und der Übertragungseinrichtung (kommend oder gehend) geändert werden. Aufgrund der erfindungsgemäßen Doppelverwendung der Steuerinformation zu Beginn eines Kanals als Adresse oder Fehlersicherungsmodusanzeige kann die Empfangseinrichtung sofort und selektiv für jeden Kanal entscheiden, welcher Übertragungsmodus vorliegt. Dabei kann auch bei Übertragung im Fehlersicherungsmodus die normale Kanaltaktung beibehalten werden. Die verwendete Art der Übertragung von Steuerinformationen gestattet eine einfache Erkennung der verschiedenen Datenformate. Dabei ist auch eine selektive Anwendung der erfindungsgemäßen Fehlersicherung auf die abgehende oder ankommende Empfangsrichtung möglich.

Mit der erfindungsgemäßen Fehlersicherung wird die Systembandbreite optimal ausgenutzt, da eine Änderung des Datenformats in einzelnen Kanälen durchgeführt werden kann und nicht jeweils ein ganzer Rahmen geändert werden muß. Hierbei ist weder eine Änderung der Übertragungsgeschwindigkeit, noch der Taktsteuerung der Empfangsmodulatoren nötig.

Im folgenden wird die Erfindung anhand von lediglich einen Ausführungsweg darstellenden Zeichnungen näher erläutert.

Es zeigt :

Fig. 1 schematisch ein Zeitmultiplexübertragungssystem mit Vielfachzugriff (TDMA-System), in dem die Erfindung in vorteilhafter Weise verwendet werden kann,

Fig. 2 das Format von ausgesandten Stationsbündeln und Bündelkanälen in dem vom Satelliten zurückgestrahlten Signalgemisch mit Zeitmultiplexbündeln in diesem Gemisch,

Fig. 3 das Format von Bündelkanälen, welche Daten in einem ungesicherten Format aussenden,

Fig. 4 das Format von gepaarten Kanälen, welche Daten mit Fehlersicherung enthalten,

Fig. 5a und 5b Verfahrensabläufe in den Stationen zur selektiven Änderung von Kanalformaten als Funktion von veränderlichen Störungsbedingungen, um einzelne Kanäle in den einzelnen Stationsbündel an die Störungsbedingungen anzupassen,

Fig. 6 Logikeinrichtungen in den Stationen zur selektiven Steuerung der Bündelübertragungsformate und

Fig. 7 Logikeinrichtungen in den Stationen zur Steuerung Empfanges von veränderlichen Kanalformaten.

Die Erfindung wird in einem Übertragungssystem mit Vielfachzugriff verwendet. In einem solchen System kommunizieren viele Stationen zugleich über einen Satelliten-Transponder miteinander. Das nachfolgend beschriebene Ausführungsbeispiel bezieht sich auf ein solches System in dem die Stationen im sog. Zeitmultiplexbetrieb mit Vielfachzugriff, d. h. im sog. TDMA-Modus arbeiten.

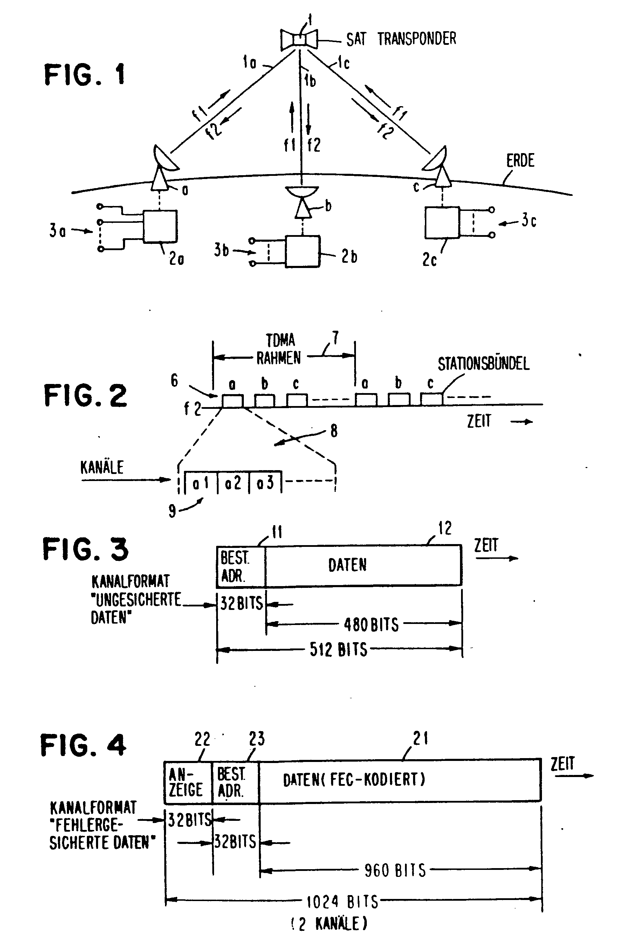

Wie in den Fign. 1 und 2 gezeigt ist, senden Erdstationen a, b und c gleichzeitig Bündel von Funksignalen auf einem gemeinsamen Frequenzband f1. Die Bündel werden zu einem Satelliten-Transponder 1 in den einzelnen Übertragungswegen 1a, 1b, 1c, ... gesandt. Jedes Bündel ist durch digitale Signale moduliert. Die einzelnen Bündel der verschiedenen Stationen kommen zeitlich nacheinander beim Satelliten in einer vorbestimmten Sequenz an, wie in Fig. 2 gezeigt ist. Im Transponder wird das Frequenzband von der Frequenz f1 auf ein Frequenzband f2 umgesetzt, wobei die Modulation in den Bündeln erhalten bleibt. Das Gemisch von zeitlich ineinander geschachtelten Bündeln im Frequenzband f2 wird vom Transponder zu allen Erdstationen gesandt. Die Stationen demodulieren das erhaltene Signalgemisch und führen die erhaltene Information über einen Demultiplexer. Dabei wird festgestellt, welche Kanäle für die jeweilige Station bestimmt sind.

Das von einer Station ausgesandte Informationsbündel kann Informationen von verschiedenen Quellen enthalten, die in verschiedenen zeitlich getrennten Kanälen ausgesendet werden. Das vom Satelliten empfangene Informationsgemisch kann also als eine zweidimensionale Multiplexinformation von zeitlich getrennten Bündeln und zeitlich getrennten Kanälen in den Bündeln angesehen werden. In dem empfangenen Gemisch können die einzelnen Kanäle verschiedene Bestimmungsstationen und verschiedene Bestimmungsanschlüsse haben. Zu jeder Station gehört eine Vermittlung 2a, 2b, 2c, ..., welche es gestatten, selektiv eine gewünschte Verbindung zwischen äußeren Anschlüsse 3a, 3b, 3c, ..., in individuell zugewiesenen Zeitkanälen in den Bündeln herzustellen.

Wie in Fig. 2 gezeigt ist, sind die einzelnen Bündel 6 in den TDMA Bündelrahmen 7 zeitlich getrennt. Im Transponder wird das Frequenzband von der Frequenz f1 auf die Frequenz f2 umgesetzt und das umgesetzte Frequenzgemisch zu den Erdstationen gesendet. Wie in Fig. 2 mit dem Bezugszeichen 8 angedeutet ist, kann ein Kanalbündel, wie z.B. das Bündel a viele zeitlich getrennte Kanäle 9 mit digitaler Information enthalten, wobei diese digitalen Informationen von verschiedenen Anschlüssen a1, a2, a3, ..., herrühren.

Die Anschlüsse 3a, 3b, 3c, ..., Fig. 1, können mit Telephonleitungen oder digitalen Übertragungsleitungen verbunden sein. Die Analog-Digitalumsetzung von Telephoniesignalen kann dabei in den gezeigten Vermittlungseinrichtungen 2a, 2b, 2c, ..., durchgeführt werden. Die digitalen Werte der zu übertragenden Sprachamplituden werden in Pufferspeichern gespeichert, bis eine vorgegebene Vielzahl von zu übertragenden Amplitudenwerten (480 Bits) pro Anschluß erreicht ist. Zu geeigneten Zeitpunkten, welche sich aus der Synchronisierung mit den Bündel-, Kanal- und Bitzeiten in den Rahmen 7 ergeben, werden die Inhalte dieser Pufferspeicher selektiv ausgelesen und zum Satelliten in Form von zeitkombinierter Modulation in den betreffenden Stationsbündel gesendet.

In der umgekehrten, abwärtsgerichteten Übertragungsrichtung wird das Frequenzgemisch der zeitlich aufeinander folgenden Bündel in den Zentralen 2a, 2b, 2c, ..., empfangen und verarbeitet. Dabei werden die Kanäle ausgesucht, welche von der betreffenden Station verarbeitet werden sollen, während andere Kanäle, die keine Information für die betreffende Station enthalten, unberücksichtigt bleiben. Eine Speicherung dieser anderen Kanäle in der betreffenden Station kann normalerweise nicht erfolgen, da die Pufferspeicher nur zur Abspeicherung der für die Station relevanten Daten ausgelegt sind. Die empfangenen relevanten Werte werden einem Demultiplexor zugeführt und über Vermittlungseinrichtungen zu den Bestimmungsanschlüssen der Station geleitet.

In Vermittlungen der in der eingangs genannten US-PS 4 009 344 beschriebenen Art kann auch eine Aktivitätskompression durchgeführt werden. Dabei werden Bündelübertragungskanäle nur solchen Telephoniesignalen zugeteilt, die Sprachsignale darstellen. Diese Zuteilung ist ähnlich der sog. TASI (time assigned speech interpolation) Methode. Eine Einrichtung dieser Art kann auch eine Steuerung enthalten, welche die Bündeldauer, d.h. die Kanalkapazität, den Anschlußanforderungen der teilnehmenden Stationen als Funktion der Verwendungsaktivität der Anschlüsse anpaßt. Die vorliegende Erfindung kann vorzugsweise im Zusammenhang mit einer solchen Aktivitätskompression und Kanalzuteilung nach Anforderung verwendet werden.

In der genannten US-PS werden die Beziehungen zwischen Durchschaltkanälen in der Zentrale und Kanalzeitschlitzen im Satellitenbündel durch Aktivitätskompressionsmasken angezeigt. Diese Masken werden in dem Bündel mitübertragen und durch Tabellen in den Zentralen wird die Beziehung dokumentiert.

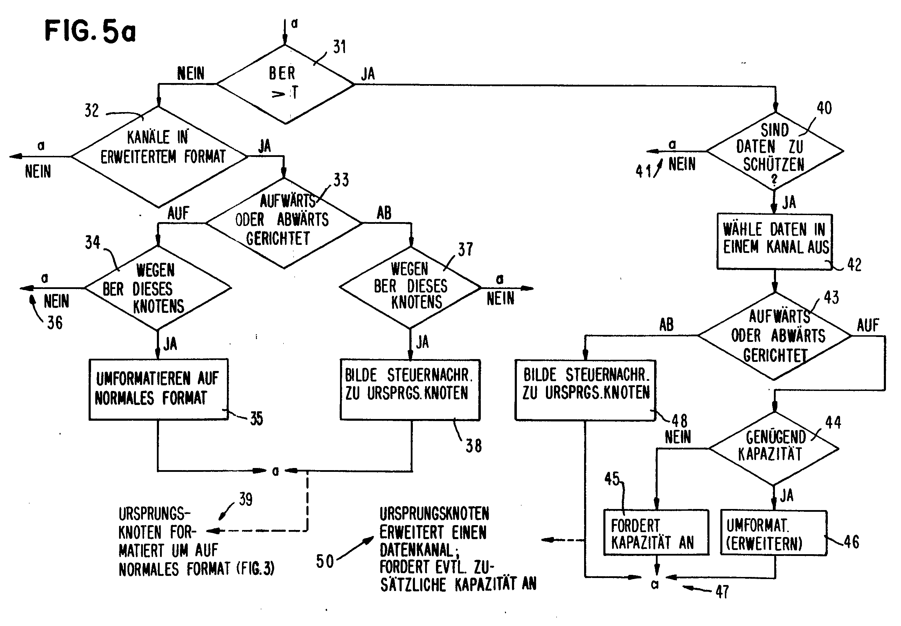

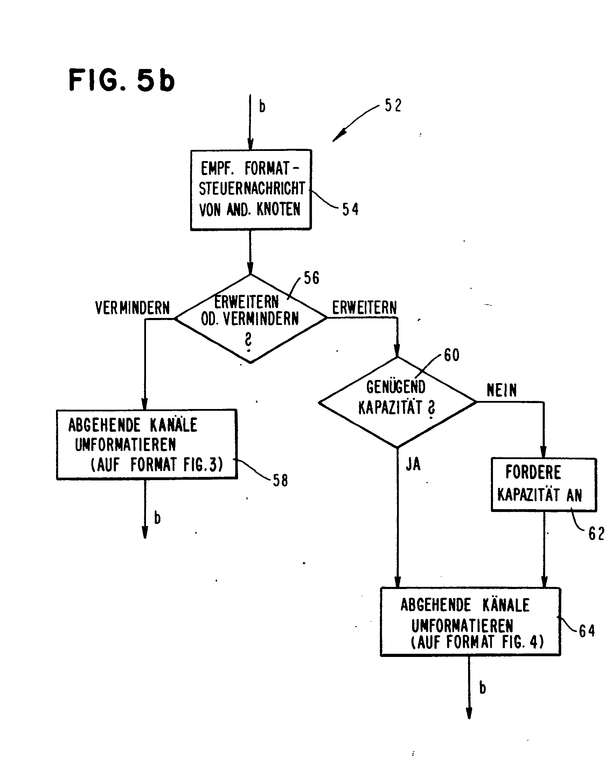

Im nachfolgend beschriebenen Ausführungsbeispiel wird jedoch eine unterschiedliche Kanalübertragungsmethode beschrieben. Jeder Kanalzeitschlitz enhält im vorliegenden Ausführungsbeispiel 512 Bitzeitschlitze. Unter störungsfreien Bedingungen werden in diesen 512 Zeitschlitzen 32 Adressenbits 11 (Fig. 3) in den erste· 32 Zeitschlitzen gesendet und geben damit die Eestimmung der Datenbits 12 in den restlichen 480 Bitzeitschlitzen an. In solchen « normalen » Kanälen haben die Datenbits 12 unveränderlich einen einzigen Ursprung und werden unveränderlich zur selben Bestimmungsadresse gesandt, wie sie durch die Adressenbits 11 dargestellt ist.

Erfindungsgemäß kann jedoch die Information in bestimmten ausgewählten Kanälen durch redundante Prüfbits geschützt werden, wenn der Übertragungsweg nicht störungsfrei ist. Das ausgesendete Kanalformat ergibt sich dabei aus Fig. 4. Die durch einen Block von 480 Bits dargestellte Information, welche gemeinsamen Ursprung und Bestimmung hat, wird in einem Doppelredundanz (16, 8)-Vorwärtsfehlerkorrekturcode (FEC) fehlergesichert und nimmt nach der Fehlercodierung den doppelten Platz, d. h. 960 Zeitschlitze 21 in dem Doppelkanal ein, der eine Kapazität von 1024 Zeitschlitzen hat. Nach der beschriebenen Fehlercodierungsmethode werden also einem Datenbyte von 8 Bit nochmals 8 redundante Prüfbits hinzugefügt, so daß sich der für di Übertragung der eigentlichen Datenbits notwendige Bitraum verdoppelt. In dem beschriebenen « 2-Kanal » Format wird in den ersten 32 Bits im ersten Kanal eine 32-Bit-Anzeige 22 gesendet, welche angibt, daß die gesendeten Daten fehlercodiert sind und die Daten in einer « 2-Kanal » Konfiguration übertragen werden. Die nächsten 32 Zeitschlitze 23, welche auf die Anzeigeinformation 22 folgen, enthalten Bestimmungsadressenbits, welche den Adressenbits 11 im normalen (ungesicherten) Kanalformat nach Fig. 3 entsprechen. Sowohl im ungeschützten Format nach Fig. 3 als auch im geschützten Format nach Fig. 4 werden die Bestimmungsadressen 11 und 23 auch in einem Doppelredundanzcode (16, 8) fehlercodiert. Dabei muß natürlich der Bereich der möglichen Codewerte den maximal zu erwartenden Adressenbereich überschreiten. In diesem Bereich der Codewerte wird ein anderweitig nicht benutzter Wert dazu verwendet die Anzeige der Information 22 darzustellen. Daher zeigt die Bestimmungsadresse 11 implizit bereits das ungesicherte Format nach Fig. 3 an und gibt die Anzeigeinformation 22 explizit das gesicherte Format nach Fig. 4 an. Es soll noch darauf hingewiesen werden, daß die Anzeigeinformation 22 und die Adresse 23 genau auf die 2-Kanal Konfiguration abgestimmt sind, da in den beiden Kanälen nur die zu übersendenden Daten infolge der zusätzlichen Fehlersicherung einen erweiterten Raum einnehmen. Auch nehmen sowohl im Format nach Fig. 3 als auch im Format nach Fig. 4 die Datenbits dieselbe Zeitdauer in Anspruch. Daher ist sowohl die verwendete Bitrate als auch das verwendete Modulationsband für beide Formate identisch.

Störungsdetektion

In den gezeigten Zentralen 2a, 2b, 2c können Steuerrechner vorgesehen werden, welche in Bezug auf die über den Satelliten übertragenen Daten mannigfaltige Berechnungen vornehmen können. Eine solche Verarbeitung der Übertragungsinformation bezieht sich auf ein Stationssynchronisierungsverfahren, nach dem gewisse von einer oder mehreren Stationen übertragene Bündel Zeitreferenzsignale zur Synchronisation aller Stationen, d.h. bezüglich eines gemeinsamen TDMA-Rahmen 7 in Fig. 2, enthalten. Sofern diese Synchronisationsbündel von nur einer Station gesendet werden, kann diese Station als Haupt- oder Referenzstation bezeichnet werden. Die Referenzsignale können dabei durch einen Doppelredundanzfehlercode codiert werden, so daß die genannten Rechner in jeder Zentrale die Häufigkeit des Auftretens von Störungen, d.h. die Bitfehlerrate BER überwachen können. Diese Bitfehlerrate kann erfindungsgemäß dazu verwendet werden, das Übertragunsformat nach Fig. 3 oder Fig. 4 für jeden Kanal einzeln festzusetzen.

Die genannte Referenzstation überwacht ebenfalls ihre eigenen Sychronisationssignale und setzt ihre Tätigkeit als Referenzstation nur solange fort, wie die Bitfehlerrate, welche von ihr festgestellt wird, innerhalb eines vorbestimmten Grenzwertes bleibt. Wenn dieser zulässige Grenzwert überschritten wird, muß das ganze System rekonfiguriert werden, um nunmehr eine andere Station als Referenzstation arbeiten zu lassen.

Wenn die von einer Empfangsstation überwachte Bitfehlerrate in dem von der Referenzstation empfangenen Signal den vorbestimmten Grenzwert überschreitet, werden Operationsschritte ausgelöst, welche individuelle Kanäle zur Übertragung im erweiterten Datenformat nach Fig. 4 auswählen. Ebenso kann bei Unterschreitung eines bestimmten Wertes der Bitfehlerrate eine Umschaltung solcher erweiterter Kanäle auf das normale Format durchgeführt werden. Die durchzuführenden Verfahrensschritte sind in einem Ablaufdiagramm in den Fign. 5a und 5b dargestellt.

Zunächst soll noch darauf hingewiesen werden, daß in dem betrachteten Zeitmultiplexübertragungssystem mit Vielfachzugriff die vom Transponder zu jeder Station übertragene Energie stark gestreut wird und daher schwach ist im Vergleich zu der Übertragungsenergie von einer Station zum Transponder. Störungen im Übertragungsweg beeinträchtigen daher normalerweise nur die ankommenden Kanäle, während die abgehenden Kanäle einer Station weit weniger beeinträchtigt werden. Bei der oben angeführten Auswahl bestimmter Kanäle zur Überführung ins erweiterte Format sollten daher ankommende Kanäle vorgezogen werden.

Wie in Fig. 5a gezeigt ist, überwacht jede Station dauernd die Bitfehlerrate im betreffenden Übertragungsweg 1a, 1b, 1c, ..., und bestimmt in gezeigten Schritt 31, ob der BER Wert den vorbestimmten Grenzwert T für zulässige Übertragungsstörungen überschreitet. Ist dies nicht der Fall, wird im Schritt 32 bestimmt, ob unter den von dieser Station behandelten Kanälen solche im erweiterten (datengesicherten) Format nach Fig. 4 vorhanden sind. Ist dies nicht der Fall, wird keine spezifische Aktion unternommen und die Bitfehlerrate wird weiterhin andauernd überwacht.

Sind jedoch Kanäle im erweiterten Format nach Fig. 4 vorhanden, bestimmt der Rechner im Schritt 33, ob diese Kanäle auf das normale Format nach Fig. 3 zurückgeführt werden können, und ob sie aufwärts- oder abwärtsgerichtet sind, d.h., ob sie von der Station abgehen oder an der Station ankommen. In Bezug auf abgehende Kanäle bestimmt die Station im Schritt 34, ob die betroffenen Kanäle erweitert wurden als Folge einer lokal festgestellten erhöhten Fehlerbitrate oder als Folge von Steuernachrichten, welche von entfernten Stationen erhalten wurden und die Formatänderung als Folge von bei diesen entfernten Stationen festgestellten erhöhten Bitfehlerraten durchgeführt wurden. Abgehende Kanäle, deren Format als Folge von lokal festgestellten Störungseigenschaften erweitert wurde, können direkt auf die normale Form nach Fig. 3 zurückgebracht werden (Schritt 35). Kanäle, welche als Folge von Steuernachrichten von entfernten Stationen erweitert wurden, sind an dieser Stelle im Ablaufdiagramm nicht betroffen (Schritt 36).

Bezüglich der Feststellungen im Schritt 33, daß Kanäle im erweiterten Format ankommend sind, wird beim Schritt 37 eine Entscheidung bezüglich der Ursache der Formatänderung gemacht (BER Bedingungen beim Ursprungsknoten oder BER Bedingungen beim betrachteten Empfangsknoten, die vorher in einer Steuernachricht dem Ursprungsknoten von diesem Knoten angezeigt wurden). Ankommende Kanäle im erweiterten Format, deren Erweiterung zurückzuführen ist auf lokale BER Bedingungen bei diesem betrachteten Knoten, werden auf das normale Format zurückgeführt (Fig. 3) durch Übertragung von Format-Steuernachrichten 38 zu den jeweiligen Ursprungsknoten und durch geeignete Aktionen 39 bei diesen Ursprungsstationen. Ankommende Kanäle im erweiterten Format, deren Erweiterung auf erhöhte Bitfehlerraten bei anderen Knoten zurückzuführen ist, sind an dieser Stelle 37 im Ablaufdiagramm nicht betroffen.

Nach der Bestimmung beim Schritt 31, daß die lokalen BER Bedingungen bei dieser Station den zulässigen Grenzwert T überschreiten, wird der Entscheidungsschritt 40 als Funktion der Art von Daten die gegenwärtig übertragen werden, durchgeführt. Wenn die Wiedergewinnung der Information in allen Kanälen, die gegenwärtig zu diesem Knoten übertragen werden, nicht durch Störungen beeinträchtigt ist, wird keine Formatänderungsaktion unternommen und der Schritt 41 umfaßt keine Aktivitäten. Wenn jedoch zumindest ein Datenkanal eine Fehlersicherungs-Codierung benötigt, wählt der Rechner in der betreffenden Station diesen Datenkanal zur Formatänderung aus, vorausgesetzt, daß genügend Kanalkapazität zur Erweiterung des Formats vorhanden ist. Wie oben bereits bemerkt wurde, sollen bei der Auswahl solcher Kanäle, deren Format erweitert werden soll, ankommende Kanäle vor abgehenden Kanälen bevorzugt werden. Des weiteren kann die Empfindlichkeit der einzelnen Kanäle gegen Störungen tabelliert werden und bei der Auswahl der Kanäle zur Formatänderung kann das Ausmaß der Störungsanfälligkeit der Kanäle berücksichtigt werden.

Das Format des ausgewählten Kanals wird im Schritt 42 erweitert. Beim Schritt 43 wird eine Entscheidung getroffen, ob der gewählte Kanal abgehend oder ankommend ist, d.h. zum Satelliten gerichtet ist, oder vom Satelliten empfangen wird. Wenn ein abgehender Kanal gewählt wird, wird beim Schritt 44 eine Bestimmung durchgeführt, ob genügend Kanalkapazität vorhanden ist, um die Formatänderung, die ja einen weiteren zusätzlichen Kanal benötigt, auffangen zu können. Wenn die gegenwärtig verfügbare Kanalkapazität in dem Kanalbündel zur Erweiterung nicht ausreicht, wird wie im Schritt 45 angedeutet zusätzliche Kapazität angefordert. Diese Anforderung kann mit Hilfe von Übertragungen von Steuernachrichten und der früher beschriebenen Zuteilungsmethode nach Anforderung durchgeführt werden. Wenn genügend Kapazität verfügbar ist, werden die Daten im ausgewählten Kanal mit Hilfe des beschriebenen Doppelredundanzfehlercodes gesichert und in zwei Kanälen übertragen (Schritt 46). Nach Durchführung der Schritte 45 oder 46 kehrt das Ablaufdiagramm zum Schritt 31 zurück (Schritt 47).

Bezüglich der Auswahl von ankommenden Kanälen beim Schritt 42 macht die im Schritt 43 durchgeführte Entscheidung die Operation nach Schritt 48 notwendig. In dieser Operation wird eine Formatsteuernachricht zu dem Knoten gesandt, von dem der ausgewählte ankommende Kanal ausgesendet wird. Diese Steuernachrichten werden in Steuerungssignalisierungskanälen innerhalb eines Stationsbündels ausgesendet. Bei der Station, welche die Steuernachricht empfängt und die zugleich die Ursprungsstation für den betrachteten Kanal ist, wird das Format des Kanals, der in der Formatsteuernachricht angegeben wird, auf die in Fig. 4 angegebene Form erweitert.

Operationen bei der fernen Station als Folge von im Schritt 38 und 48 ausgesendeten Formatsteuernachrichten sind im Schritt 52, Fig. 5b dargestellt. Die Formatsteuernachricht wird im Schritt 54 empfangen und eine Bestimmung wird beim Schritt 56 bezüglich der Art der verlangten Aktion gemacht. In Bezug auf Steuernachrichten, welche eine Reduktion, d.h. eine Zurückführung auf das normale Format von angegebenen abgehenden Datenkanälen angeben, wird im Schritt 58 direkt die Formatreduzierung vorgenommen. Im Bezug auf angezeigte abgehende Datenkanäle, welche auf das Format nach Fig. 4 erweitert werden sollen, bestimmt die Station im Schritt 60, ob genügend Kanalkapazität zur Erweiterung vorhanden ist. Ist dies nicht der Fall, wird zusätzliche Kapazität angefordert, wie im Schritt 62 dargestellt ist und die Formaterweiterung wird im Schritt 64 durchgeführt. Falls beim Schritt 60 festgestellt wird, daß genügend Kapazität vorhanden ist, wird die Formaterweiterung direkt durchgeführt.

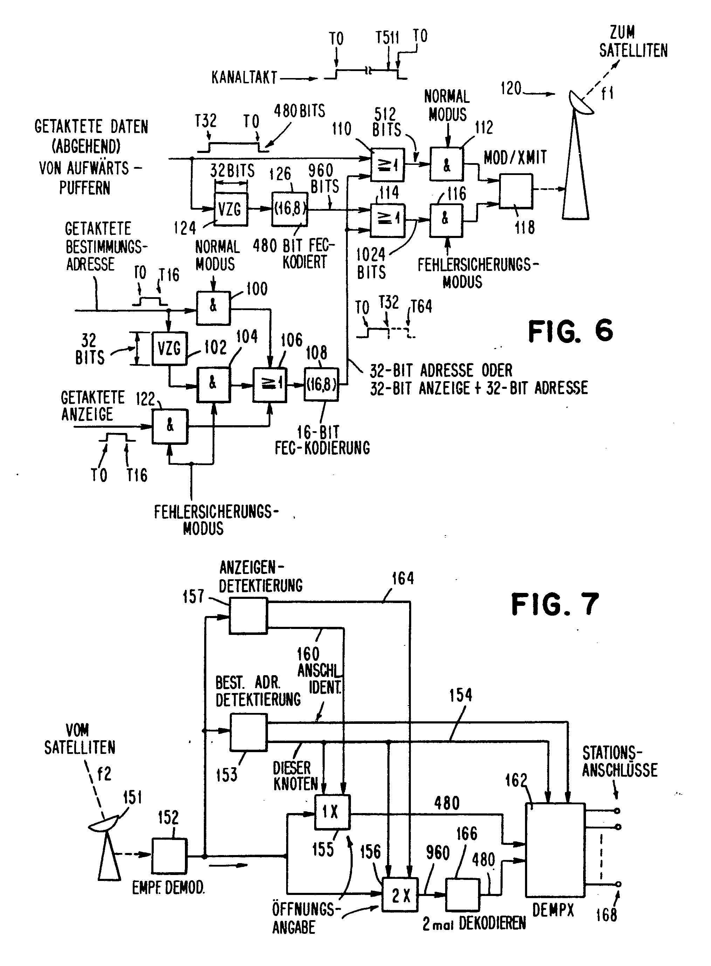

Die in den Stationen notwendige Einrichtung zur Durchführung der Formatänderungen sind in den Fign. 6 und 7 dargestellt. In Fig. 6 gibt TO den Beginn eines abgehenden Bündels von 512 Bitzeitschlitzen bei der Datenaussendung an. Die Bestimmungsadresse für jeden abgehenden Kanal ist durch 16 Bits angegeben und wird einem UND-Glied 100 zugeführt. Ebenso gelangen die 16 Adressenbits über eine Verzögerungsschaltung 102 von 32 Bitzeitschlitzen zum UND-Glied 104. Das UND-Glied 100 ist im Normalmodus (Format nach Fig. 3) durchgeschaltet und das UND-Glied 104 im Datensicherungsmodus (Format nach Fig. 4). Die Ausgangssignale der Glieder 100 und 104 gelangen über ein ODER-Glied 106 zum Codierer 108, welcher die 16 eingegebenen Datenbits durch Hinzufügen von 16 weiteren redundanten Prüfbits auf 32 Bits erweitert. Hierdurch wird erreicht, daß die Nachricht in einem Vorwärts-Fehlerkorrekturcode ausgesandt wird, so daß Fehler beim Empfang erkannt und korrigiert werden können. Die genannten 32 Bits gelangen über das ODER-Glied 110 zum UND-Glied 112 und über das ODER-Glied 114 zum UND-Glied 116. Das UND-Glied 112 wird durchgeschaltet, so daß das vom ODER-Glied 110 kommende Signal zur Aussendung im Normalmodus gelangen kann, während das UND-Glied 116 durchgeschaltet wird, so daß das Signal vom ODER-Glied 114 zur Aussendung gelangen kann, wenn eine Aussendung in fehlergesicherter Betriebsweise gewünscht wird. Die Ausgänge der UND-Glieder 112 und 116 gelangen zu einer Modulations- und Sendeschaltung 118, von wo sie über die Antenne 120 per Funk ausgesendet werden.

Weiters wird die 16-Bit Bestimmungsadresse von den UND-Schaltungen 100 und 104 einem Fehlercodierer zugeführt und die von diesem FEC-Codierer 108 erhaltenen 32 Bits werden entweder in den ersten 32 Bitzeitschlitzen des gegenwärtigen Zeitkanals (Zeitschlitze TO bis T31) ausgesendet, wenn die UND-Schaltungen 100 und 112 durchgeschaltet sind, oder in den folgenden 32 Bitzeitschlitzen (Taktzeiten T32 bis T63), wenn die UND-Schaltungen 104 und 116 durchgeschaltet sind.

Im Fehlersicherungsmodus wird eine 16-Bit-Anzeige (22, Fig. 4) über das UND-Glied 122 und das ODER-Glied 106 dem Codierer 108 zugeführt und in eine fehlergesicherte 32-Bit Form umgewandelt, wobei die Aussendung in den ersten 32 Bitzeitschlitzen des nächstfolgenden abgehenden Kanals erfolgt. Ferner wird das Ausgangssignal des Codierers 108 über das ODER-Glied 114 und das UND-Glied 116 der Modulations- und Sendeeinrichtung 118 zur Aussendung zugeführt. Im Fehlersicherungsmodus (Format nach Fig. 4) wird also in den ersten 32 Bitzeitschlitzen des Kanals ein Anzeigesignal ausgesendet, welches dazu dient, der Empfangsstation die Formaterweiterung anzuzeigen.

Während der restlichen Zeitschlitze (T32 bis T511) des gegenwärtig ausgesandten Zeitkanals wird ein Block von 480 Datenbits zur Aussendung aus nicht gezeigten Sendepufferspeichern ausgewählt. Diese Daten gelangen über das ODER-Glied 110 zum UND-Glied 112 und über die Verzögerungsschaltung 124 von 32 Bitzeitschlitzen zum FEC-Codierer 126. Das Ausgangssignal dieses Codierers hat die in Fig. 4 angegebene Form von 960 FEC codierten Datenbits 21. Das Ausgangssignal des Codierers 126 gelangt über das ODER-Glied 114 zum UND-Glied 116.

Im Normalmodus ist also das UND-Glied 112 durchgeschaltet und bringt die Daten in der normalen 480 Bitform (Fig. 3) zu den Sendeeinrichtungen 118 und 120, während im Fehlersicherungsmodus das UND-Glied 116 die um 32 Bits verzögerten Daten in der 960-Bit Fehlersicherungsform in zwei Bündelkanälen zu den Sendeeinrichtungen weiterleitet. Von den Sendeeinrichtungen werden also entweder in der Normalform eine Bestimmungsadresse und 480 Datenbits oder nach dem Fehlersicherungsmodus eine 32-Bit-Anzeige, gefolgt von einer Bestimmungsadresse und 960 fehlercodierten Datenbits ausgesendet. In beiden Fällen wird derselbe Bittakt verwendet und deshalb ist die Modulationsbandbreiten-Verwendung in beiden Fällen identisch.

Die für die Erfindung wesentlichen Empfangseinrichtungen einer Station sind in Fig. 7 dargestellt. Die Antenne 151 empfängt vom Satelliten ein Informationsgemisch auf dem Trägerfrequenzband f2 und dieses Gemisch wird von den Empfangs- und Demodulationseinrichtungen 152 weiter verarbeitet. Die Bestimmungsadresse in jedem Kanal identifiziert einen bestimmten Bestimmungsknoten (oder Vielfachknoten) und gegebenenfalls einen bestimmten Bestimmungsanschluß der angegebenen Bestimmungsstation. Bei Übereinstimmung der Bestimmungsadresse und der Adresse der betrachteten Station gibt die Vergleichschaltung 153 ein Ausgangssignal auf der Leitung 154 ab, wodurch die Tore « 1X » 155 und « 2X » 156 teilweise durchgeschaltet werden. Über das Tor 155 werden 480 Bits und über das Tor 156 960 Bits übertragen. Wenn von den Schaltungen 157 keine formatanzeige (22, Fig. 4) detektiert wird, führt die Leitung 160 ein Signal und vollendet die Durchschaltung des Datenöffnungstores 155. Hierdurch gelangen 480 Datenbits nach dem in Fig. 3 gezeigten Normalformat zum Stationsdemultiplexor 162.

Wenn jedoch eine Formatanzeige von den Schaltungen 157 festgestellt wird, erscheint auf der Leitung 164 ein Signal und schaltet das Datenöffnungstor 156 durch. Hierbei gelangen die im erweiterten Format nach Fig. 4 übertragenen 960 fehlercodierten Datenbits zu den Decodierschaltungen 166, welche die 960 FEC Bits in die ursprünglichen 480 Datenbits decodieren und zum Demultiplexor 162 weiter leiten. Dieser Demultiplexor 162 gibt bei einer Datenübertragung die betreffenden Daten ab oder kann bei einer Telephonie-übertragung die in analoge Form umgesetzten Amplitudenwerte abgeben.

Die Erfindung kann auch auf andere Weise verwendet werden. Wenn z.B. bei der Daten- oder Sprachübertragung über die Stationen 2a, 2b, 2c, ... (Fig. 1) eine Gebührenberechnung für die von den Teilnehmeranschlüssen 3a, 3b, 3c, ausgesendeten Informationen stattfindet, kann abhängig davon, ob ein Teilnehmer eine Aussendung im Normalformat oder Datensicherungsformat wünscht, eine entsprechende Gebührenberechnung durchgeführt werden. Dabei kann auch berücksichtigt werden, ob ein Teilnehmer generell, oder nur für ein zelne Nachrichten eine Fehlersicherung nach der vorliegenden Erfindung wünscht. Der Vorteil der beschriebenen Fehlersicherungsmethode liegt darin, daß eine wirkungsvolle Fehlersicherung auf einer selektiven Basis unter verschiedenen Störungsverhältnissen möglich wird. Dabei kann auch für jeden Datenkanal die Wichtigkeit der Daten, ihre Störungsanfälligkeit und die insgesamt verfügbare Kanalkapazität berücksichtigt werden. Die beschriebene Formatdarstellung nach den Fign. 3 und 4 gestattet eine unverwechselbare Unterscheidung der Bestimmungsadressenangabe und der Formatanzeige.

Im oben beschriebenen Ausführungsbeispiel wird zur Durchführung einer Datenübertragung im Fehlersicherungsmodus eine Formatänderung durchgeführt. Die Formatänderung kann dabei entweder in abgehender oder in ankommender Richtung, oder auch in beiden Richtungen durchgeführt werden. Die Formatänderung kann nach der vorliegenden Erfindung zeitlich begrenzt durchgeführt werden und es ist jederzeit eine Rückführung auf den Normalmodus durchführbar. Dadurch, daß die beschriebene Fehlersicherung nicht nur auf die Daten, sondern auch auf die Bestimmungsadresse und die Formatanzeige angewendet wird, wird eine zusätzliche Übertragungssicherheit erzielt. Die Erfindung vermeidet auch eine Änderung der Bitübertragungsrate bei einer Formatumschaltung, so daß eine Anpassung der Demodulationseinrichtungen oder der Bittakteinrichtungen bei den Empfangsstationen infolge einer Formatänderung unnötig sind.

**Ansprüche**

1. Verfahren zur Datenübertragung mit Messung der Bitfehlerrate und adaptiver Fehlersicherung von Informationzeichen mit Hilfe von Fehlerkorrekturzeichen in einem Zeitmultiplexsystem mit Vielfachzugriff (TDMA-System), wobei die Fehlerkorrekturzeichen anstelle von Informationszeichen übertragen werden können und die von jeder Datenübertragungsstation ausgesandten Kanalbündel Signaladressen und Steuerzeichen aufweisen, und wobei abhängig von der gemessenen Bitfehlerrate in einem Normal-Übertragungsmodus (1. Betriebsart) ungesicherte Information und in einem Fehlerkorrektur-Übertragungsmodus (2. Betriebsart) durch Korrekturzeichen gesicherte Information übertragen werden kann, dadurch gekennzeichnet, daß zu Beginn jeder Kanalinformation eine Steuerinformation gesendet wird, die im Normal-Übertragungsmodus als Bestimmungsadresse (11, Fig. 3) und im Fehlerkorrektur-Übertragungsmodus als diesen Modus anzeigender Wert (22, Fig. 4) beim Empfang der Daten decodierbar ist, wodurch ein auf die Steuerinformation nachfolgendes, gleich langes Feld (23, Fig. 4) als Bestimmungsadresse und der Rest (21, Fig. 4) von zwei oder mehreren benachbarten Kanälen entsprechend dem Inhalt der Steuerinformation als Informationszeichen und Korrekturzeichen verarbeitet werden.

2. Verfahren nach Anspruch 1, dadurch gekennzeichnet, daß die Daten mittels eines Doppel-Redundanz-Vorwärts-Fehlerkorrekturcodes (FEC, z.B. 16/8) fehlergesichert werden.

3. Verfahren nach Anspruch 1, dadurch gekennzeichnet, daß in der ersten Betriebsart auch die Bestimmungsadresse (11) und in der zweiten Betriebsart auch die Modusanzeige (22) und die Bestimmungsadresse (23) fehlergesichert werden.

4. Sendeeinrichtung zur Durchführung des Verfahrens nach Anspruch 1 dadurch gekennzeichnet, daß die auszusendenden Daten in der ersten Betriebsart über ein erstes ODER-Glied (110, Fig. 6) und ein erstes UND-Glied (112), das im Normal-Modus durchgeschaltet ist, ausgesendet werden, daß die Daten in der zweiten Betriebsart um die zur Aussendung einer Bestimmungsadresse nötigen Zeit in einer ersten Verzögerungsschaltung (124) verzögert, sowie in einem ersten Doppel-Redundanz-Vorwärts-Fehlercodierer (126) codiert werden und über ein zweites ODER-Glied (114) und ein zweites, in der zweiten Betriebsart durchgeschaltetes UND-Glied (116) ausgesendet werden, daß die Bestimmungsadresse in der ersten Betriebsart über ein drittes in dieser Betriebsart durchgeschaltetes UND-Glied (100), sowie über ein drittes ODER-Glied (106) und einen zweiten Fehlercodierer (108) dem ersten und zweiten ODER-Glied (110, 114) zugeleitet wird, daß die Bestimmungsadresse ferner über eine zweite Verzögerungsschaltung (102) mit gleicher Verzögerung wie die erste Verzögerungsschaltung und ein viertes UND-Glied (104) dem dritten ODER-Glied zugeleitet wird, und daß eine Modusanzeige über ein fünftes UND-Glied (122) dem dritten ODER-Glied zugeleitet wird, wobei das vierte (104) und das fünfte (122) UND-Glied von einem die zweite Betriebsart anzeigenden Signal durchgeschaltet werden.

5. Empfangseinrichtung zur Durchführung des Verfahrens nach Anspruch 1 gekennzeichnet durch eine Detektierungsschaltung (157, Fig. 7) für die Modusanzeige (22, Fig. 4), durch eine Detektierungsschaltung (153) für die Bestimmungsadresse, durch ein erstes Datenöffnungstor (155) zum Übertragen einer Kanallänge, durch ein zweites Datenöffnungstor (156) zum Übertragen von zwei Kanallängen, wobei das erste Tor (155) geöffnet wird, wenn die Anzeigedetektierungsschaltung (157) kein Signal liefert und das zweite Datentor (156) geöffnet wird, wenn die Anzeige der Detektierungsschaltung (157) ein Ausgangssignal (164) liefert, und dadurch, daß der Ausgang des zweiten Datenöffnungs Tors (156) über einen zu den Codieren komplementären Decodierer (166) mit einem Demultiplexor (162) verbunden ist, der eingangsseitig auch mit dem ersten Datenöffnungstor (155) verbunden ist und von der Bestimmungsadressen-Decodierungsschaltung (153) gesteuert wird.

6. Einrichtung nach den Ansprüchen 4 und 5, dadurch gekennzeichnet, daß die Daten vom Datensender (Fig. 6) auf einem ersten Frequenzband (f1) zu einem Satelliten-Transponder (1) gesendet, und auf einem zweiten Frequenzband (f2) vom Transponder wieder ausgesendet und vom Datenempfänger (Fig. 7) empfangen werden.

## Claims

1. Data communication method including measurement of the bit error rate and adaptive error protection of information codes by means of error correction codes in a time division multiple access system (TDMA system), wherein error correction codes can be transmitted instead of information codes and the channel information bursts transmitted by each data communication station include signal addresses and control characters, and wherein, depending on the measured bit error rate, unprotected information can be transmitted in a first normal transmission mode, and information protected by error correction codes can be transmitted in a second error-correction transmission mode, characterised in that control information is transmitted at the beginning of each channel information, said control information being decodable as destination address (11, Fig. 3) in the normal transmission mode and as mode indicator (22, Fig. 4) in the error-correction transmission mode at the reception of data, whereby a field of equal length (23, Fig. 4) following said control information can be processed as destination address, and the rest (21, Fig. 4) of two or more adjacent channels can be processed as information code or error-correction code according to the contents of the control information.

2. Method according to claim 1, characterised in that data are protected by means of a double redundancy forward error correction code (FEC, e.g. 16/8).

3. Method according to claim 1, characterised in that the destination address (11) in the first mode and mode indication (22) and destination address (23) in the second mode are error protected.

4. Transmitter means for the implementation of a method according to claim 1, characterised in that data to be transmitted in said first mode are transmitted through a first OR-gate (110, Fig. 6) and a first AND-gate (112) passing data in the normal mode, that data to be transmitted in the second mode are delayed in a delay circuit (124) by the period required for the transmission of a destination address as well as encoded in a first double redundancy forward error encoding circuit (126), and are transmitted through a second OR-gate (114) and a second AND-gate (116) passing data in the second mode, that the destination address is passed to the first and second OR-gates (110, 114) in the normal mode through a third AND-gate (100) passing data in this mode, as well as through a third OR-gate (106) and a second error encoding circuit (108), that the destination address is furthermore fed to the third OR-gate (106) through a second delay circuit (102), having the same delay time as the first delay circuit, and a fourth AND-gate (104), and that a mode indication is fed to said third OR-gate through a fifth AND-gate (122), wherein said fourth and fifth AND-gates (104, 122) are switched to pass a second mode indicator signal.

5. Receiver means for the implementation of a method according to claim 1, characterised by comprising a flag detector circuit (157, Fig. 7) for the mode indicator (22, Fig. 4), a receiving node comparison circuit (153), a first data reception aperture gate (155) for the transmission of one channel length and second data reception aperture gate (156) for the transmission of two channel lengths, wherein said first gate (155) is opened, if said flag detector circuit (157) gives no output signal, and said second gate (156) is opened, if said flag detector circuit (157) gives an output signal (164), that the output of said second aperture gate (156) is connected to a demultiplexor (162) via a decoder (166) complementary to said encoders, said demultiplexor (162) being connected with its input side to the first aperture gate (155) and controlled by the receiving node comparison circuit (153).

6. Means according to claims 4 and 5, characterised in that data is transmitted from a data transmitter (Fig. 6) to a satellite transponder (1) on a first frequency band (f1) and retransmitted from said transponder and received by a data receiver (Fig. 7) on a second frequency band (f2).

**Revendications**

1. Procédé de transmission de données comportant la mesure du taux d'erreur de bit et la correction adaptable des erreurs de code d'information à l'aide de codes de correction d'erreur dans un système à accès multiple par répartition dans le temps (système TDMA), procédé dans lequel les codes de correction d'erreur peuvent être transmis à la place des codes d'information, dans lequel les rafales de canaux émises par chaque station de transmission de données comportent des adresses et des codes de contrôle, et dans lequel on peut transmettre, en fonction du taux d'erreur de bit mesuré, dans un mode de transmission standard (premier mode de fonctionnement) des données non protégées, et dans un mode de transmission de correction d'erreur (second mode de fonctionnement) des données protégées par des codes de correction, caractérisé en ce qu'au début de chaque information de canal on émet une information de contrôle qui, dans le mode de transmission standard, est décodée comme adresse de destination (11, figure 3) et, dans le mode de transmission de correction d'erreur, comme indicateur de ce mode (22, figure 4) lors de la réception des données, ce qui a pour résultat qu'un champ de même longueur (23, figure 4) succédant à l'information de contrôle est traité comme adresse de destination, et que le reste (21, figure 4) de deux ou plusieurs canaux adjacents est traité soit comme codes d'information soit comme codes de correction selon le contenu de l'information de contrôle.

2. Procédé selon la revendication 1, caractérisé en ce que les données sont protégées à l'aide d'un code de correction d'erreur à double redondance (FEC, par exemple 16/8).

3. Procédé selon la revendication 1, caractérisé en ce que dans le premier mode de fonctionnement on protège également l'adresse de destination (11), et dans le second mode de fonctionnement, on protège l'indicateur de mode (22) et l'adresse de destination (23).

4. Dispositif de transmission pour réaliser le procédé selon la revendication 1, caractérisé en ce que les données à émettre dans le premier mode de fonctionnement sont transmises à travers une première porte OU (110, figure 6) et une première porte ET (112) qui est passante en mode normal, en ce que les données à émettre dans le second mode de fonctionnement sont retardées dans un premier circuit à retard (124) par le temps nécessaire pour transmettre une adresse de destination et sont codées dans un premier codeur de code de correction d'erreur à double redondance (126) pour être ensuite transmises à travers une seconde porte OU (114) et une seconde porte ET (116) qui est passante dans le second mode de fonctionnement, en ce que l'adresse de destination est transmise aux première et seconde portes OU (110, 114), dans le premier mode de fonctionnement à travers une troisième porte ET (100) qui est passante dans ce même mode et à travers une troisième porte OU (106) ainsi qu'à travers un second codeur de code de correction d'erreur (108), en ce qu'en outre l'adresse de destination est transmise à la troisième porte OU à travers un second circuit à retard (102) qui introduit le même retard que celui introduit par le premier circuit à retard, et à travers une quatrième porte ET (104), et en ce qu'un indicateur de mode est transmis, à travers une cinquième porte ET (122), à la troisième porte OU, les quatrième (104) et cinquième (122) portes ET étant rendues passantes par un signal indiquant le second mode de fonctionnement.

5. Dispositif de réception pour réaliser le procédé selon la revendication 1, caractérisé en ce qu'il comporte un circuit de détection (157, figure 7) pour l'indicateur du mode (22, figure 4), un circuit de détection (153) pour l'adresse de destination, une première porte d'ouverture de données (155) pour la transmission d'une longueur de canal, une seconde porte d'ouverture de données (156) pour la transmission de deux longueurs de canal, la première porte (155) étant ouverte lorsque le circuit de détection d'indicateur (157) ne fournit pas de signal et la seconde porte de données (156) étant ouverte lorsque le circuit de détection (157) fournit un signal de sortie (164), et en ce que la sortie de la seconde porte d'ouverture de données (156) est connectée à un démultiplexeur (162) à travers un décodeur (166) complémentaire aux codeurs, ledit démultiplexeur étant également connecté du côté entrée avec la première porte d'ouverture de données (155) et commandé par le circuit de décodage d'adresse de destination (153).

6. Dispositif selon les revendications 4 et 5, caractérisé en ce que les données sont transmises par le dispositif de transmission de données (figure 6) sur une première bande de fréquence (f1) à un transpondeur de satellites (1) et qu'elles sont retransmises par le transpondeur sur une seconde bande de fréquence (f2) pour être reçue par un dispositif de réception de données (figure 7).

**FIG. 1**

SAT TRANSPONDER

f1 f2 f1 f2 f1 f2

ERDE

3a 2a 3b 2b 2c 3c

**FIG. 2**

TDMA RAHMEN 7

STATIONSBÜNDEL

6 a b c a b c

f2 ZEIT →

8

KANÄLE a1 a2 a3

9

**FIG. 3**

11 12 ZEIT →

KANALFORMAT "UNGESICHERTE DATEN"

BEST. ADR. DATEN

32 BITS

480 BITS

512 BITS

**FIG. 4**

22 23 21 ZEIT →

KANALFORMAT "FEHLERGE-SICHERTE DATEN"

AN-ZEIGE BEST. ADR. DATEN (FEC-KODIERT)

32 BITS

32 BITS

960 BITS

1024 BITS

(2 KANÄLE)

1

FIG.5a

31 — BER > T — JA / NEIN

32 — KANÄLE IN ERWEITERTEM FORMAT — JA / NEIN

33 — AUFWÄRTS ODER ABWÄRTS GERICHTET — AUF / AB

34 — WEGEN DIESER KNOTENS — JA / NEIN 36

35 — UMFORMATIEREN AUF NORMALES FORMAT

37 — WEGEN DER DIESES KNOTENS — JA / NEIN

38 — BILDE STEUERNACHR. ZU URSPRGS.KNOTEN

39 — URSPRUNGS-KNOTEN FORMATIERT UM AUF NORMALES FORMAT (FIG.3)

50 — URSPRUNGSKNOTEN ERWEITERT EINEN DATENKANAL; FORDERT EVTL. ZU-SÄTZLICHE KAPAZITÄT AN

40 — SIND DATEN ZU SCHÜTZEN? — JA / NEIN 41

42 — WÄHLE DATEN IN EINEM KANAL AUS

43 — AUFWÄRTS ODER ABWÄRTS GERICHTET — AUF / AB

44 — GENÜGEND KAPAZITÄT — JA / NEIN

46 — UMFORMAT. (ERWEITERN) 47

45 — FORDERT KAPAZITÄT AN

48 — BILDE STEUERNACHR. ZU URSPRGS.KNOTEN

# FIG. 5b

b → 52

EMPF. FORMAT-
STEUERNACHRICHT
VON AND. KNOTEN — 54

56
VERMINDERN ← ERWEITERN
OD. VERMINDERN
?
→ ERWEITERN

60
GENÜGEND
KAPAZITÄT ?
NEIN →

ABGEHENDE KANÄLE
UMFORMATIEREN
(AUF FORMAT FIG.3) — 58

b

JA

FORDERE
KAPAZITÄT AN
62

ABGEHENDE KÄNALE
UMFORMATIEREN
(AUF FORMAT FIG. 4) — 64

b

3

FIG. 6

FIG. 7